# EUROPEAN PATENT SPECIFICATION

(11) **EP 4 028 625 B1**
(45) Date of publication and mention of the grant of the patent: **22.01.2025**
(21) Application number: 20771836.2
(22) Date of filing: 11.09.2020
(51) Int. Cl.: E21B 7/12, E21B 19/00, E21B 19/09, E21B 7/128

(54) **METHOD OF PLANNING AND/OR PERFORMING AN OFFSHORE WELL OPERATION**
VERFAHREN ZUR PLANUNG UND/ODER DURCHFÜHRUNG VON OFFSHORE-BOHROPERATIONEN
PROCÉDÉ DE PLANIFICATION ET/OU DE RÉALISATION D'UNE EXPLOITATION DANS UN PUITS EN MER

(30) Priority: 12.09.2019 GB 201913138
(43) Date of publication of application: 20.07.2022
(73) Proprietor: Heavelock Solutions AS, 7462 Trondheim (NO)
(72) Inventor: KVERNLAND, Martin, 7462 Trondheim (NO); GORSKI, Dmitri, 7462 Trondheim (NO); AAMO, Ole Morten, 7462 Trondheim (NO); SANGESLAND, Sigbjørn, 7462 Trondheim (NO)
(74) Representative: Lincoln, Matthew
(86) International application number: PCT/EP2020/075560
(87) International publication number: WO 2021/048416

(56) References cited:
- WO-A1-2015/183492
- WOJCIECH STANISLAW CHRZANOWSKI: "Managed Pressure Drilling from Floaters: Feasibility Studies for Applying Managed Pressure Drilling from a floater on the Skarv/Idun field on the Norwegian Continental Shelf by PGNiG Norway AS", 15 June 2011 (2011-06-15), pages 1 - 130, XP055074979, Retrieved from the Internet <URL:https://uis.brage.unit.no/uis-xmlui/handle/11250/183392> [retrieved on 20130813]
- STRECKER TIMM ET AL: "Rejecting heave-induced pressure oscillations in a semilinear hyperbolic well model", 2017 AMERICAN CONTROL CONFERENCE (ACC), AACC, 24 May 2017 (2017-05-24), pages 1163 - 1168, XP033110068, DOI: 10.23919/ACC.2017.7963110

## Description

The present invention relates to a method of planning and/or performing an offshore well operation, and in particular to a method of planning and/or performing a well operation using a computer software method. An aspect of the invention relates to a method of simulating downhole pressure variations during an offshore drilling or completion operation, and the application of such a method to the planning and/or performing of offshore drilling or completion from a floating drilling rig or ship.

### Background to the invention

In the offshore industry for the exploration and production of hydrocarbons, it is known to run strings of tubulars or pipe string into and out of a wellbore during drilling operations, the installation of completions, or intervention operations. During drilling, mechanical heave compensation systems topside are used to compensate for vertical movement (heave) of the drilling rig, and reduce or eliminate the effect on the drill string and drill bit. However, there are two instances in a drilling operation when the drill string is normally not heave-compensated. One is when the drill string is extended with a new drill pipe section or stand by making a drill pipe connection, the drill pipe must be suspended in slips and is mechanically fastened to the rig floor. The top of the drill string will therefore experience the same vertical movement as the rig floor due to heave of the rig.

A second example is during a tripping or pulling operation, during which the drill string is pulled out of the well to change a component and then run it back into the well. During tripping or pulling, the heave-compensation system is normally not used in order to avoid limiting the speed of the operation. Movements induced by the rig heave are then superimposed on the tripping/pulling speed.

When not compensated against heave, the drill string will act as a piston in the well, inducing pressure variations (referred to as "surge and swab") that may exceed the pressure margins of the well. The problem is also applicable during completion operations, when a casing or a liner is installed into the well.

Exceeding well pressure margins may lead to a number of undesired consequences, such as a hydrocarbon kick if the lower pressure limit (pore pressure) is passed, or mud losses, non-productive time, wellbore breathing/ballooning and/or lower future well productivity if the upper pressure limit (fracture pressure) is exceeded.

It would generally be desirable to mitigate against the undesired consequences of heave-induced pressure variations on drilling, completion and/or intervention operations.

EP 2404031 describes a drilling control system which creates an operational envelope that can be used by the driller to limit the velocity of the drill string while tripping/pulling. This functionality is to limit the speed of the drill string being pulled out of the well, or inserted into the well, based on simulations of the well parameters.

US 9,695,655 proposes to counteract downhole pressure fluctuations by dynamically choking the return flow of mud topside on the rig. This method is limited to systems in which a choke is installed on the return flow (such as Managed Pressure Drilling systems) and is in practice limited in its applicability by the time delays experienced between a change implemented topside and its effect downhole.

US 10,156,105 describes a drill apparatus having a controllable dynamic flow restriction operable to restrict fluid flow through the drill string when the drill string moves downwards in the well to generate excess pressure in the drill string to allow for compensation of heave induced pressure fluctuations downhole.

Wojciech Stanislaw Chrzanowski (University of Stavanger, Master's Thesis, pp. 1-130, 2011) describes and evaluates different technologies that can be used in Managed Pressure Drilling. Additionally, the technical and economic feasibility of using different technologies in Managed Pressure Drilling from floating platforms is described, and the need for a model that can predict the downhole pressure when making connections is discussed.

Strecker Timm et al. (Americans Control Conference, pp. 1163-1168, 2017) describes an output feedback controller that can be used to reject heave-induced pressure oscillations in a semilinear hyperbolic well model.

WO 2015/183492 describes a method for calculating the elasticity of a drill string and for calculating the surge and swab pressure acting on the drill string during a drilling operation. A method for determining a set point pressure, and operating a choke system based on the set point pressure to regulate a predetermined downhole pressure, are also further described.

### Summary of the invention

It is amongst the aims and objects of the invention to provide a method of predicting and/or accounting for heave-induced pressure variations during the planning or performance of a well operation such as drilling or completion.

It is amongst the aims and objects of the invention to provide a method of calculating wellbore pressures, taking account of heave-induced variations derived from updated or real-time wave or weather information.

According to a first aspect of the invention, there is provided a method of planning or performing an offshore well operation performed from a floating offshore structure in a subsea well, the method comprising:
predicting the effect of heave on the well operation by:
providing heave motion data for the floating offshore structure to a processing module;
running a well operation simulation model on the processing module;
calculating a wellbore pressure using the well operation simulation model, wherein the calculation of wellbore pressure uses the heave motion data to calculate the effect of heave motion on the well operation;
comparing the calculated wellbore pressure with at least one pressure margin for the subsea well to determine a risk associated with a planned deactivation of a heave compensation system during the well operation; and
outputting risk information from the processing module.

The at least one pressure margin may comprise a pore or wellbore collapse pressure of the subsea well, and/or may comprise a fracture pressure of the subsea well.

The risk associated with the well operation may include (but is not limited to) a risk of a wellbore pressure exceeding or passing a pressure margin of the subsea well during the well operation or a phase of the well operation.

The risk associated with the well operation may include (but is not limited to) a risk of the well operation or a phase of the well operation causing one or more of: a well fracture, wellbore collapse, fluid losses, fluid influx, wellbore breathing/ballooning, production of solids, non-productive time, lower future well productivity, a risk of damage to a completion or wellbore, or a risk of blow out.

The method may comprise outputting risk information to an operator, or may comprise outputting risk information to a control system for the well operation.

The risk information may include a risk level, which may comprise for example a zero risk, a low risk, a medium risk, or a high risk. It will be appreciated that a greater or lesser number of risk levels may be used within the method. The method may comprise categorising the well operation or a phase or the well operation as being safe or unsafe, recommended or not recommended, or other such risk categorisations that may be incorporated into the method.

The risk information may comprise a risk type, which may include, but is not limited to, a risk of the well operation or a phase of the well operation causing one or more of: a well fracture, well collapse, fluid losses, fluid influx, wellbore breathing/ballooning, production of solids, a risk of damage to a completion, or a risk of blow out.

The well operation may be an operation in which a string or tubular is run into or pulled out of the subsea well. The string may be a drill string, and may comprise rigid drill pipe, or may comprise a coiled tubing string. Alternatively, or in addition, the string may be a completion string or tubular, for example a casing, liner, or production tubular.

The well operation may be a drilling operation, a completion operation, or an intervention operation.

Preferably the heave motion data is calculated from input data relating to one or more weather conditions and/or sea state conditions. The input data may comprise forecast data relating to weather conditions and/or sea state conditions. The input data may comprise wave height data and/or wave period data, which may be forecast wave height data and/or forecast wave period data.

The heave motion data may comprise a stochastic time series of an expected or predicted heave motion, which may be calculated from input data using a response amplitude operator (RAO) of the offshore structure.

The method comprises determining a risk associated with deactivation of a heave compensation system. The method may comprise categorising a planned deactivation of a heave compensation system as being safe or unsafe, recommended or not recommended, or other such risk categorisations that may be incorporated into the method.

In an embodiment of the invention, the well operation uses a string or tubular which is formed from sections assembled together at string or tubular connections. The string or tubular connections may be threaded connections. The well operation may comprise making and/or breaking a string or tubular connection.

The method may comprise determining a risk associated with a planned making or breaking of a string or tubular connection. The method may comprise categorising a planned making or breaking of a string or tubular connection as being safe or unsafe, recommended or not recommended, or other such risk categorisations that may be incorporated into the method.

The method may comprise determining a risk associated with an upcoming phase of the operation, for example a finite period of time into the future (such as a period of 0 to 12 hours), based on forecast wave data and/or forecast weather data at the operation site. The method may comprise categorising a planned deactivation of a heave compensation system during the upcoming phase of the operation based on forecast wave data and/or forecast weather data at the operation site. The method may therefore provide a recommendation signal and/or information to assist decision making concerning operational actions during the finite period of time.

The well operation simulation model may comprise a plurality of well operation parameters selected from the group consisting of:
well fluid properties;
drilling fluid characteristics, including but not limited to drilling mud density or viscosity;
rate of flow or circulation of drilling fluid;
well trajectory;
tripping/pulling speed;
pipe and tubular material constants, such as elasticity described by Young's Modulus;
rate of penetration;
status of a heave compensation system;
status of a Continuous Circulation System (CCS):
   status of the surface backpressure choke;
   drill bit position (i.e. the measured depth to the bit from the rig floor);
   well friction factors (static and/or dynamic).
   riser level.

The method may comprise setting one or more parameters of the well operation simulation model. Alternatively, the plurality of well operation parameters may be pre-configured in the well operation simulation model. The method may comprise setting one or more parameters of the well operation simulation model, with a subset of other well operation parameters being pre-configured in the well operation simulation model.

The method may comprise updating one or more parameters of the well operation simulation model and running the well operation simulation with the updated one or more parameters to calculate a wellbore pressure using the heave motion data and updated one or more parameters to calculate the effect of heave motion on the well operation. For example, in a drilling operation, parameters relating to mud properties (including but not limited to drilling mud density or viscosity and rate of mud circulation) or well trajectory, which may change through the course of a drilling operation, may be changed and the effect on wellbore pressure calculated using the method.

Preferably the heave motion data is calculated from input data relating to one or more weather conditions and/or sea state conditions. The input data may comprise forecast data relating to weather conditions and/or sea state conditions. The input data may comprise wave height data and/or wave period data, which may be forecast wave height data and/or forecast wave period data.

The method may comprise updating heave motion data and running the well operation simulation with the updated heave motion data to calculate a wellbore pressure. The heave motion data may be updated by calculating from updated input data relating to one or more weather conditions and/or sea state conditions. The updated input data may comprise updated forecast data relating to weather conditions and/or sea state conditions. The input data may comprise wave height data and/or wave period data, which may be forecast wave height data and/or forecast wave period data.

Thus the well operation simulation model, and/or the heave motion data, may be updated according to the latest input data available to a user of the system, including scheduled, planned, desired or necessary changes to well operation parameters, and/or updated input data relating to one or more weather conditions and/or sea state conditions (such as updated forecasts of wave height data and/or wave period data).

The method may comprise updating the well operation simulation model, and/or the heave motion data, repeatedly, and may comprise updating the well operation simulation model, and/or the heave motion data at regular intervals. The method may comprise updating the well operation simulation model, and/or the heave motion data, continuously or in real-time, according to the availability of new or updated well operation parameters and/or heave motion data.

The method may comprise changing a first selected parameter of the well operation simulation model, and running the well operation simulation with the changed first selected parameter to calculate a wellbore pressure using the heave motion data and changed first selected parameter to calculate the effect of heave motion on the well operation.

The method may comprise comparing the calculated wellbore pressure with at least one pressure margin for the subsea well to determine a risk associated with the well operation with the changed first selected parameter.

The method may comprise changing a first selected parameter of the well operation simulation model in response to a determined risk associated with the well operation. For example, if the method determines that the well operation or a phase of the well operation has an unacceptable risk, the method may comprise changing a first selected parameter to determine whether the well operation with the changed first selected parameter has different associated risk information.

The method may comprise repeating the steps of changing a first selected parameter of the well operation simulation model, and running the well operation simulation with the changed first selected parameter to calculate a wellbore pressure using the heave motion data and changed first selected parameter until the well operation or a phase of the well operation is determined to have an acceptable risk. The changed first selected parameter may be output from the processing module, and may be displayed to an operator.

The method may comprise optimising the first selected parameter in accordance with an acceptable risk profile of the well operation of a phase of the well operation.

The method may comprise determining a range of the first selected parameter that comply with an acceptable risk profile for the well operation or a phase of the well operation. The range of the first selected parameter may be output from the processing module, and may be displayed to an operator.

The method may comprise activating an alarm signal to an operator if the first selected parameter does not comply with an acceptable risk profile for the well operation or a phase of the well operation.

The first selected parameter may comprise a tripping/pulling speed of a string or tubular in the wellbore, and the method may comprise determining a range of tripping speeds that comply with an acceptable risk profile for the well operation or a phase of the well operation. The range of tripping/pulling speeds may be output from the processing module, and may be displayed to an operator.

The method may comprise activating an alarm signal to an operator if the tripping/pulling speed does not comply with an acceptable risk profile for the well operation or a phase of the well operation.

The method may comprise outputting risk information to a control system for the well operation, and the control system may automatically control one or more parameters of the well operation. The control system may, for example, inhibit or prevent deactivation of a heave compensation system. The control system may, for example, inhibit or prevent a selected parameter moving outside of a range that complies with an acceptable risk profile for the well operation or a phase of the well operation. The control system, may, for example, prevent continuation or commencement of the well operation or a phase of the well operation.

The method may comprise changing a second, third or further selected parameter of the well operation simulation model, and running the well operation simulation with the changed second, third, or further selected parameter to calculate a wellbore pressure using the heave motion data and changed second, third or further selected parameter to calculate the effect of heave motion on the well operation. The method may comprise repeating the steps of changing a second, third or further selected parameter of the well operation simulation model, and running the well operation simulation with the changed second, third or further selected parameter to calculate a wellbore pressure using the heave motion data and changed second, third or further selected parameter until the well operation or a phase of the well operation is determined to have an acceptable risk.

The method may comprise optimising a second, third or further selected parameter in accordance with an acceptable risk profile of the well operation of a phase of the well operation.

There may be provided a method of planning a drilling operation performed from a floating offshore structure in a subsea well, the method comprising:
providing heave motion data for the floating offshore structure to a processing module;
running a drilling simulation model on the processing module;
calculating a wellbore pressure using the drilling simulation model, wherein the calculation of wellbore pressure uses the heave motion data to calculate the effect of heave motion on the drilling operation;
comparing the calculated wellbore pressure with at least one pressure margin for the subsea well to determine a risk associated with the drilling operation;
and outputting information relating to the risk from the processing module.

The method may comprise determining a risk associated with a planned making or breaking of a drill string connection. The method may comprise categorising a planned making or breaking of drill string connection as being safe or unsafe, recommended or not recommended, or other such risk categorisations that may be incorporated into the method.

The method may comprise determining a risk associated with deactivation of a heave compensation system. The method may comprise categorising a planned deactivation of a heave compensation system as being safe or unsafe, recommended or not recommended, or other such risk categorisations that may be incorporated into the method.

The method may comprise using the calculated wellbore pressure to determine a maximum recommended rig heave value at which making or breaking a drill pipe connection has an acceptable risk, for example by not leading to breaching of the well pressure margins for different parts of the well.

There may be provided a method of performing a drilling operation from a floating offshore structure in a subsea well, the method comprising:
providing heave motion data for the floating offshore structure to a processing module;
running a drilling simulation model on the processing module;
calculating a wellbore pressure using the drilling simulation model, wherein the calculation of wellbore pressure uses the heave motion data to calculate the effect of heave motion on the drilling operation;
comparing the calculated wellbore pressure with at least one pressure margin for the subsea well to determine a risk associated with deactivation of a heave compensation system for an upcoming phase of the drilling operation;
outputting information relating to the risk from the processing module.

The risk information may include a risk level, which may comprise for example a zero risk, a low risk, a medium risk, or a high risk. It will be appreciated that a greater or lesser number of risk levels may be used within the method. The method may comprise categorising the drilling operation or a phase or the drilling operation as being safe or unsafe, recommended or not recommended, or other such risk categorisations that may be incorporated into the method.

The method may comprise activating an alarm signal to an operator if the risk level does not comply with an acceptable risk profile for the drilling operation or a phase of the drilling operation.

The method may comprise controlling the drilling operation or a phase or the drilling operation using the control system if the risk level does not comply with an acceptable risk profile for the drilling operation or a phase of the drilling operation. The method may comprise controlling one or more parameters of the drilling operation or a phase or the drilling operation using the control system; inhibiting the drilling operation or a phase of the operation; or preventing continuation or commencement of the drilling operation or a phase of the drilling operation.

Preferably the heave motion data is calculated from input data relating to one or more weather conditions and/or sea state conditions. The input data may comprise forecast data relating to weather conditions and/or sea state conditions. The input data may comprise wave height data and/or wave period data, which may be forecast wave height data and/or forecast wave period data.

The method may comprise updating heave motion data and running the drilling operation simulation with the updated heave motion data to calculate a wellbore pressure. The heave motion data may be updated by calculating from updated input data relating to one or more weather conditions and/or sea state conditions. The updated input data may comprise updated forecast data relating to weather conditions and/or sea state conditions. The input data may comprise wave height data and/or wave period data, which may be forecast wave height data and/or forecast wave period data.

Thus the well operation simulation model, and/or the heave motion data, may be updated according to the latest input data available to a user of the system, including scheduled, planned, desired or necessary changes to drilling operation parameters, and/or updated input data relating to one or more weather conditions and/or sea state conditions (such as updated forecasts of wave height data and/or wave period data).

The method may comprise updating the drilling simulation model, and/or the heave motion data, repeatedly, and may comprise updating the drilling simulation model, and/or the heave motion data at regular intervals. The method may comprise updating the drilling simulation model, and/or the heave motion data, continuously or in real-time, according to the availability of new or updated drilling parameters and/or heave motion data.

There may be provided a method of performing a well operation from a floating offshore structure in a subsea well, the method comprising:
providing heave motion data for the floating offshore structure to a processing module;
running a well operation simulation model on the processing module;
calculating a wellbore pressure using the well operation simulation model, wherein the calculation of wellbore pressure uses the heave motion data to calculate the effect of heave motion on the well operation;
comparing the calculated wellbore pressure with at least one pressure margin for the subsea well to determine a risk associated with deactivation of a heave compensation system for an upcoming phase of the well operation;
outputting information relating to the risk from the processing module.

There may be provided method of performing a well operation from a floating offshore structure in a subsea well, the method comprising:
providing a first set of heave motion data for the floating offshore structure;
running a well operation simulation model on a processing module;
calculating a wellbore pressure using the well operation simulation model, wherein the calculation of wellbore pressure uses the first set of heave motion data to calculate the effect of heave motion on the well operation;
comparing the calculated wellbore pressure with at least one pressure margin for the subsea well to determine a risk associated with deactivation of a heave compensation system for an upcoming phase of the well operation;
receiving second set of heave motion data;
calculating a second wellbore pressure using the well operation simulation model, wherein the calculation of wellbore pressure uses the second set of heave motion data to calculate the effect of heave motion on the well operation;
comparing the calculated second wellbore pressure with at least one pressure margin for the subsea well to determine an updated risk associated with deactivation of a heave compensation system for an upcoming phase of the well operation.

There may be provided a computer software application configured to perform the method of any previous aspect of the invention on computer hardware.

There may be provided a system comprising a computer processor configured to execute the method of any previous aspect of the invention.

### Brief description of the drawings

There will now be described, by way of example only, various embodiments of the invention with reference to the drawings, of which:
Figure 1 is a schematic representation of a method according to a first embodiment of the invention;
Figure 2 is a schematic representation of a method of processing a risk output from the method of Figure 1, in accordance with an embodiment of the invention;
Figure 3 is a view of an exemplary operator interface for use with the method of Figure 1, as applied to a drilling operation in real-time; and
Figure 4 is a view of an exemplary graphical display for use with the method of Figure 1, as applied to planning of a future well operation.

### Detailed description of preferred embodiments

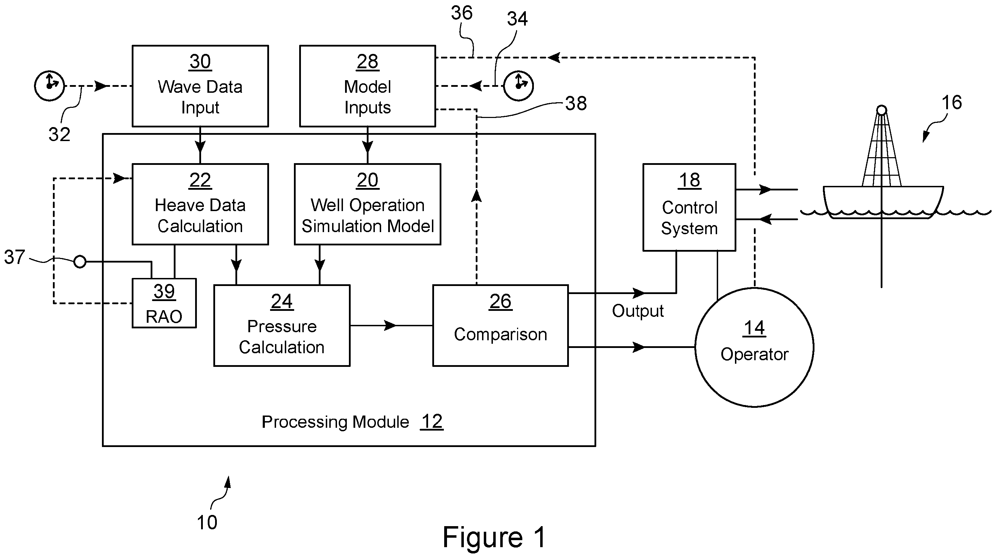

Referring firstly to Figure 1, there is a schematic representation of a method according to a first embodiment of the invention, generally shown at 10. An objective of the method 10 is to provide information on the effect of heave-induced surge and swab on pressure in a subsea well, to facilitate planning and/or performing a well operation from a floating offshore structure (including but not limited to a drilling operation, a completion operation, or an intervention operation). The method 10 is configured to be implemented with the use of a processing module 12, and in a preferred embodiment of the invention the method is implemented in computer software running on a computer processor (not shown).

The processing module 12 provides an output to an operator 14 of the system. In an application of the method to performing a well operation, the operator 14 and the processing module 12 communicate with a control system 18 for operational parts of floating offshore structure 16. The operator 14, processing module 12 and control system may be wholly or partially on the offshore structure, or may be remotely in communication with the offshore structure via communications links according to industry standards.

As will be described below, the method also has application to planning of a future well operation, and in such an application the control system and the offshore structure may not be in communication with the processing module or the operator.

The processing module 12 is configured to run a well operation simulation model 20, which is a mathematical simulation of the well operation to be performed, based on operational parameters that have a bearing on the operation. Computer software packages incorporating operation simulation models are available in the oil and gas industry, and the equations and mathematical relationships between well operation parameters are known from industry and academic literature. Background information on the relationships between well operation parameters, some of which are useful in embodiments of the present invention, are found in References #1 to #4.

The model parameters or a subset of them may be input (28) to configure the model, or the model parameters may be at least partially pre-configured. Parameters included in the model of a drilling operation may include some or all of the following:
- well geometry parameters and drill string geometry parameters, such as the well path (i.e. its trajectory in three dimensions), inner and outer diameters of drill pipe, heavy drill pipe, bottomhole assembly, casings, liners, marine riser and open hole;
- pipe and tubular material constants, such as elasticity described by Young's Modulus;
- drill bit position (i.e. the measured depth to the bit from the rig floor);
- topside drilling fluid mud pump flow rate;
- tripping/pulling speed;
- rate of penetration;
- status of a heave compensation system;
- topside choke opening and backpressure pump flow (particularly for managed pressure drilling (MPD) operations);
- fluid parameters, such as fluid density, plastic viscosity (PV), yield point (YP), low-shear-rate yield point (tau_y), bulk modulus/ compressibility factor;
- status of a CCS (Continuous Circulation System);
- well friction factors (static and/or dynamic);
- riser level.

Fluid parameters used in the model may be taken from product datasheets, manual measurements or real-time measurements, or combinations thereof.

The well operation simulation models the drill string or tubing string as a hydraulic transmission line. The model is numerically solved by spatially discretising equations governing the transmission of pressure in a fluid in the drill string or tubing string. Control volumes are defined in which pressure nodes are located, and flow nodes are defined on the interfaces between pressure nodes as a staggered grid.

The well geometry parameters enable different cross-sectional flow areas along the pipe and annulus, representing the different sections of a well such as riser, cased section, and open hole. A three-dimensional well curvature can be established in the model, resulting in simulation of changes hydrostatic pressure and additional contact friction between the tubing string and the wellbore wall or casing.

A Herschel-Bulkley type rheology is used to model the drilling mud, with frictional pressure drop calculations based on American Petroleum Institute (API) recommended practice 13D.

The method 10 calculates heave motion data 22 from input data 30 relating to wave height and wave period. The input data 30 generates a wave spectrum from statistically probable wave heights and periods for a fixed time period. The heave motion data 22 is calculated as a stochastic or randomised time series of an expected heave motion based on the chosen wave spectrum and the response amplitude operator (RAO) of the offshore structure.

From the calculated heave data 22 and the well operation model 20, the wellbore pressure is calculated 24, taking account of the pressure effect of the well operation itself, and the heave-induced pressure variations during there is no heave compensation acting on the tubing string. Flow and pressure in the tubing string and in the annulus are simulated for the duration of the absence of heave-compensation, which may be for a planned making or breaking of a tubular connection, or a period in which the string is tripped/pulled from the well. The pressure data from 24 is compared (26) with pressure margins of the well, and a risk associated with the well operation is determined.

Optionally, the drill string stress and velocity are also simulated to include the effects of elasticity. When an elastic drill string is used, the drill string is segmented using the same segment lengths as the fluid segments, while the heavy weight drill pipe and BHA is modelled as a rigid body, to provide output values relating to drill string stress and/or velocity.

Information relating to the risk is output from the processing module to the operator, and optionally direct to the control system 18, and the operator and/or the control system may therefore monitor and optionally intervene in the well operation.

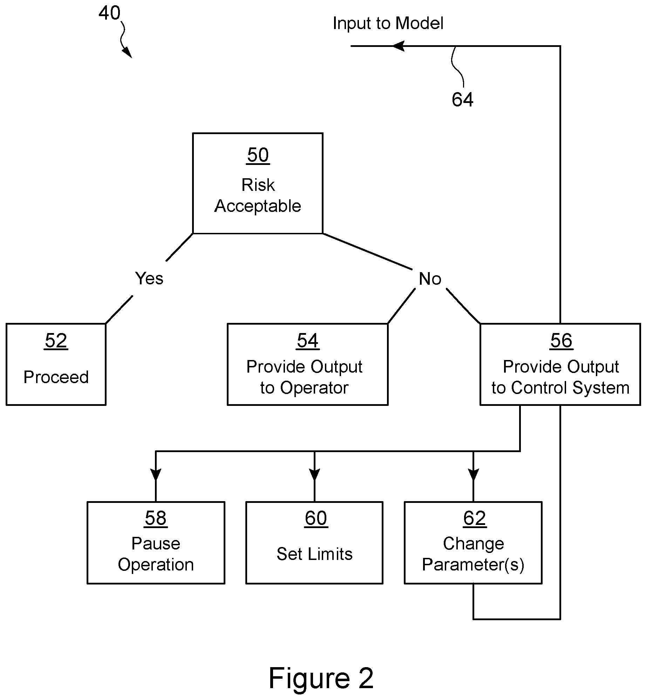

Figure 2 is a schematic representation of a method of how the risk output from the method of Figure 1 may be used by the operator or by the control system. The method, generally shown at 40, includes a determination 50 of whether the calculated pressure is acceptably within the pressure margins of the well. Optionally, the method may also at 50 determine a risk type, for example a risk of a well fracture, well collapse, fluid losses, fluid influx, production of solids, a risk of damage to a completion, or a risk of blow out, which may be weighted by significance to the well operation. The method determines whether the overall risk is acceptable and whether the operation can proceed (52) or whether information is to be output to the operator (54) and/or the control system (56). An output to an operator may be a visual and/or audible warning to the operator, along with a visual, textual, or graphical representation of the risk.

A range of different options are available to the operator, for example pausing the operation (58), setting limits on parameters of the operation (60), or changing parameters of the operation (62). Optionally, as represented by input line 36 in Figure 1, changed parameters of the operation are input into the model to recalculate the wellbore pressure according to the changed parameter, and reassess the risk. The output of the method with the changed parameter may inform the operator on a suitable change to the operation to mitigate the risk of pressure margins being exceeded or passed.

Optionally, the control system 18 may automatically intervene in the well operation according to the risk determination, for example pausing the operation (58), setting limits on parameters of the operation (60), or changing parameters of the operation (62).

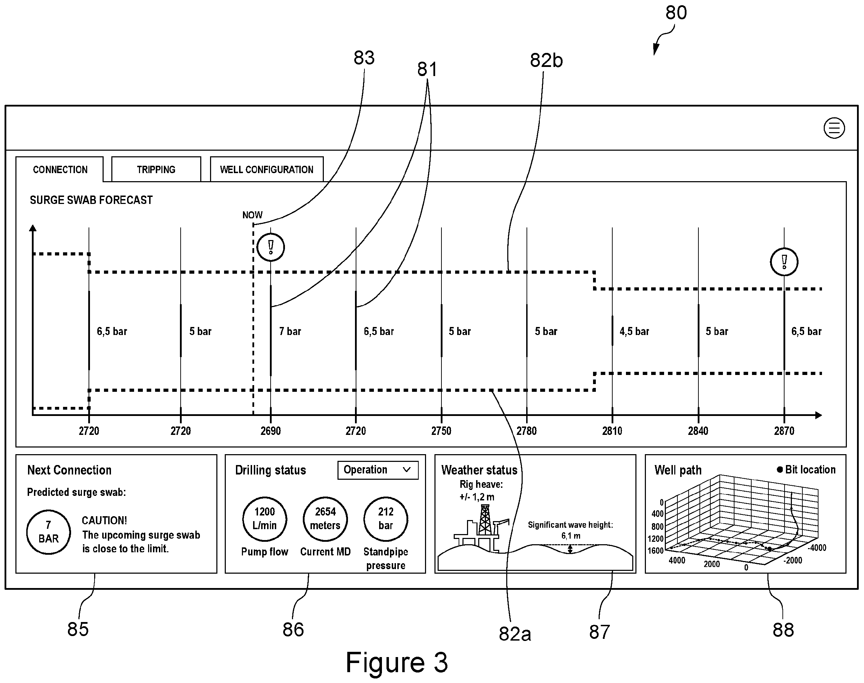

An example application of the method of Figures 1 and 2 will now be described with reference to Figure 3. Figure 3 is a view of an exemplary operator interface for use with the method of Figure 1, as applied to a drilling operation in real-time. The interface, generally shown at 80, includes a graphical representation of wellbore pressure variations due to heave effects on a drill string for an upcoming phase of a drilling operation. The panel titled "Surge Swab Forecast" plots wellbore pressure variations (around a pressure gradient of the well) against depth of bit on the x-axis. Pressure lines 81 correspond to the predicted pressure variations calculated at depths at which making a drill pipe connection is necessary as the drilling operation progresses. At these depths it is necessary to deactivate heave compensation for the duration of making the connection. Horizontal lines 82a, 82b correspond to the pressure margins of the well. Line 83 indicates the current depth of the drill bit.

The user interface 80 includes further panels presenting additional information to the operator. Panel 85 provides a visual and textual representation of the risk associated with the next drill pipe connection, at 2690m depth on the main panel. The next connection has been calculated as having a surge swab effect close to the pressure margins, resulting in a visual and textual warning to the operator. Panels 86, 87 and 88 present information on drilling status, weather status and well path respectively.

The main panel also shows predicted pressure variations for future drill string connections. In this example, the connection at 2870m has been categorised as a risk, as the surge swab effect is very close to the pressure margins at that point in the well.

The pressure predictions 81 will be updated automatically when updated wave data is available and is input into the processor (as represented by line 32 of Figure 1). Updated input wave data may comprise updated forecast data relating to weather conditions and/or sea state conditions. The input data may comprise wave height data and/or wave period data, which may be used in the calculation of heave motion data in the method.

In addition, the pressure predictions 81 will be updated automatically when there are updates in physical parameters of the drilling operation. For example, parameters relating to mud properties (including but not limited to drilling mud density or viscosity and rate of mud circulation) or well trajectory, may change through the course of a drilling operation, and may be input into the model (represented by line 34 in Figure 1), and the effect on wellbore pressure may be recalculated in real-time using the method. Optionally, pressure predictions are be provided for the bottom of the well, the location of the bit and for the casing shoe depth.

Thus the well operation simulation model, and/or the heave motion data, may be updated according to the latest input data available to a user of the system, including scheduled, planned, desired or necessary changes to well operation parameters, and/or updated input data relating to one or more weather conditions and/or sea state conditions to provide real-time information relating to the risk associated with an upcoming connection.

In a variation to the above-described embodiment, a change to a drilling parameter in the model can be made to assess the effect of that change on the pressure prediction and its associated risk. If a risk is associated within an upcoming connection, the operator or an automatic response from the control module can change a parameter and recalculate the pressure prediction. For example, a CCS (Continuous Circulation System) allows the driller to continue circulating drilling mud through the drill string during drill pipe connections, and is known to provide surge and swab reduction. The method can be used to predict the pressure variations with or without CCS, to provide information on whether it is necessary or desirable to maintain circulation on the upcoming connection or not. The system can also provide the lowest circulation rate required during a connection to minimize hole washout.

For tripping operations, a range of tripping speeds that comply with pressure margins under the prevailing heave conditions may be calculated by changing the value of a tripping speed in the well model, calculating a changed value of a pressure prediction, and determining a range of tripping speeds that comply with an acceptable risk profile for the well operation or a phase of the well operation. The range of tripping speeds may be output from the processing module, and may be displayed to the operator. Changes to the tripping speed may be made by the operator (line 36, Figure 1) or may result from a comparison of the pressure prediction with the pressure margin in the processing module in an iterative process (line 38, Figure 1).

The method as described above is configured to provide decision support through graphic user interface and alarms, for example a signal to abort drilling operations or a signal to slow down tripping/pulling speed, but in alternative embodiments, the control system 18 is capable of automatically controlling one or more parameters of the well operation. The control system may, for example, inhibit or prevent deactivation of the heave compensation system, or may inhibit or prevent a selected parameter (e.g. tripping speed) from moving outside of a range that complies with an acceptable risk profile for the well operation or a phase of the well operation. The control system, may prevent continuation or commencement of the well operation or a phase of the well operation.

Other outputs of the system may include margins for the mud weight line, and a weather window, or maximum allowed wave height and period.

The method described above is in the context of a drilling operation, but it should be appreciated that the invention also relates to completion operations, including running and installation of setting strings, completion strings, casings, liners, and production tubing into wellbores, and other similar operations that involve running tubulars or tripping tools into a well. In completion applications, setting string and completion string geometries are significant parameters of the model used in the calculation of a predicted pressure.

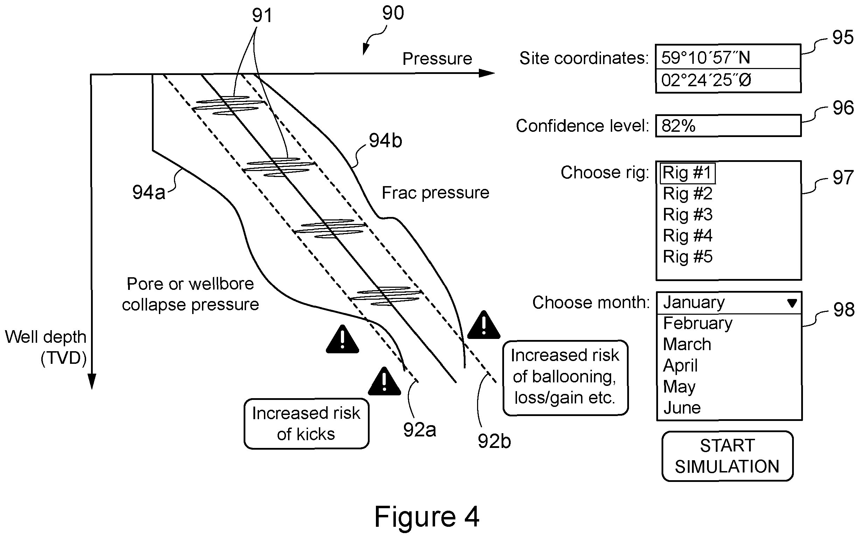

The invention also has application to planning of a drilling operation or a completion operation, as described with reference to Figure 4, which is a view of an exemplary graphical display for use with the method of Figure 1 as applied to planning of a future well operation, generally shown at 90. In a planning method, an operator is able to select from a range of parameters to see the effect on surge and swab pressure variations and make choices for the drilling and/or completion of a certain well.

In a well planning method, the heave motion data is calculated based on the predicted weather data for the drilling site prevailing at a selected drilling time (shown in Figure 4 as a selected month 98). A wave spectrum can be generated from statistically probable wave heights and periods for the drilling period, and the heave motion data is calculated as a stochastic or randomised time series of an expected heave motion based on the chosen wave spectrum and the response amplitude operator (RAO) of the selected offshore structure 97.

The planning method uses the approach of Figure 1 to calculate mud weight line margins 92a, 92b based on the selected rig (97) and time of year (98). The mud weight line margins 92a, 92b will be calculated by the model depending on the selected inputs, and if these margins cross with the predicted pore or fracture pressure, the operator may select an alternative rig 97 or time of year 98 until the risk associated with the drilling operation is acceptable.

The method is also applicable to planning completion operations, in which case the operator may be able to select from various completion parameters such as length and dimensions of casing and liners to determine their influence on the predicted pressure variations.

Variations to the described embodiments are within the scope of the invention. For example, the method may use real-time measurements of heave to calculate bottom hole pressure on the nearest connections in real-time. It will also use real-time measurements (such as mud properties, changes in geometry and other measurements) to improve its accuracy. The processing module may obtain data from the drilling system or rig, and may learn from data (for example using Machine Learning Algorithms) in order to improve predictions. One such example is shown in Figure 1, in which the wave input data 30 includes current sea state data available from weather stations offshore, and heave data is available from rig sensors 37. The simulator can optimise the RAO (i.e. improve it over time) using measured rig heave data and comparing (39) with data calculated using the RAO, to be used to improve future heave calculations.

Alternatively, or in addition, although the schematic representation in Figure 1 depicts the outputs of a calculation of heave data and the well operation simulation model to be used in a subsequent processing step, alternatives are possible within the scope of the invention. For example, wave data may be input into the well operation simulation model, which incorporates the calculation of heave data within the simulation model, to provide an output pressure calculation from the model. In another variant, heave motion data may be input directly into the processor and/or model for use in the pressure calculation. It will also be appreciated that processing steps may be split between multiple processing modules, or carried out in a single processor as depicted in Figure 1, without deviating from the scope of the invention.

The invention provides a method of predicting the effect of heave on an offshore well operation performed from a floating offshore structure in a subsea well. The method includes providing heave motion data for the floating offshore structure, and running a well operation simulation model. A wellbore pressure is calculated using the well operation simulation model and the heave motion data to calculate the effect of heave motion on the well operation. The calculated wellbore pressure is compared with at least one pressure margin for the subsea well to determine a risk associated with the well operation. The invention may be used to assess a risk associated with deactivating a heave compensation system during a particular phase of the operation. Preferred embodiments of the invention use updated or real-time wave or weather data to calculate the effects of heave motion on wellbore pressure.

Various modifications to the above-described embodiments may be made within the scope of the invention, and the invention extends to combinations of features other than those expressly claimed herein.

### REFERENCES

| | |
|---|---|
| #1 | Kvernland, M., Christensen, M.Ø., Borgen, H., Godhavn, J.M., Aamo, O.M. and Sangesland, S., 2018, March. Attenuating Heave-Induced Pressure Oscillations using Automated Down-hole Choking. In IADC/SPE Drilling Conference and Exhibition. Society of Petroleum Engineers. |
| #2 | Kvernland, M., Gorski, D., Sant'Ana, M., Godhavn, J.M., Aamo, O.M. and Sangesland, S., 2019, March. Verification of Downhole Choke Technology in a Simulator Using Data from a North Sea Well. In SPE/IADC International Drilling Conference and Exhibition. Society of Petroleum Engineers. |
| #3 | Schwarzkopf, J.D., Sommerfeld, M., Crowe, C.T. and Tsuji, Y., 2011. Multiphase flows with droplets and particles. CRC press. |
| #4 | Young, W.C., Budynas, R.G. and Sadegh, A.M., 2002. Roark's formulas for stress and strain (Vol. 7). New York: McGraw-Hill. |

## Claims

1. A method (10) of planning or performing an offshore well operation performed from a floating offshore structure (16) in a subsea well, the method comprising:
predicting the effect of heave on the well operation by:
providing heave motion data (22) for the floating offshore structure to a processing module (12);
running a well operation simulation model (20) on the processing module;
calculating a wellbore pressure (24) using the well operation simulation model, wherein the calculation of wellbore pressure uses the heave motion data to calculate the effect of heave motion on the well operation;
comparing the calculated wellbore pressure with at least one pressure margin for the subsea well to determine a risk associated with a planned deactivation of a heave compensation system during the well operation; and
outputting risk information from the processing module.

2. The method (10) according to any preceding claim, wherein the well operation is a drilling operation, a completion operation, or an intervention operation.

3. The method (10) according to any preceding claim, wherein the heave motion data (22) is calculated from input data (30) relating to one or more weather conditions and/or sea state conditions.

4. The method (10) according to any preceding claim, wherein the heave motion data (22) comprises a stochastic time series of an expected heave motion, calculated from input data (30) using a response amplitude operator (RAO) of the offshore structure.

5. The method (10) according to any preceding claim, wherein the well operation uses a string or tubular which is formed from sections assembled together at string or tubular connections, and the well operation may comprise making and/or breaking a string or tubular connection, and wherein the method comprises categorising a planned making or breaking of a string or tubular connection according to a risk level.

6. The method (10) according to any preceding claim, comprising providing a recommendation signal to assist decision making concerning the planned deactivation of the heave compensation system during an upcoming phase of the operation.

7. The method (10) according to any preceding claim, comprising:
categorising a planned deactivation of a heave compensation system during an upcoming phase of the operation based on forecast wave data and/or forecast weather data at an operation site;
and providing a recommendation signal to assist decision making concerning the planned deactivation of the heave compensation system during the upcoming phase of the operation.

8. The method (10) according to any preceding claim, comprising updating one or more parameters of the well operation simulation model (20) and running the well operation simulation with the updated one or more parameters to calculate a wellbore pressure (24) using the heave motion data (22) and updated one or more parameters to calculate the effect of heave motion on the well operation.

9. The method (10) according to any preceding claim, comprising updating heave motion data (22) and running the well operation simulation (20) with the updated heave motion data to calculate a wellbore pressure (24).

10. The method (10) according to claim 9, wherein the heave motion data (22) is updated by calculating updated heave motion data from updated input data (30) relating to one or more weather conditions and/or sea state conditions.

11. The method (10) according to any preceding claim, comprising updating the well operation simulation model (20), and/or the heave motion data (22), regularly, continuously or in real-time, according to the availability of new or updated well operation parameters and/or heave motion data.

12. The method (10) according to any preceding claim, comprising determining a value or range of values for a first selected parameter that comply with an acceptable risk profile for the well operation or a phase of the well operation, and outputting the value or range of values for the first selected parameter from the processing module (12).

13. The method (10) according claim 12, comprising activating an alarm signal to an operator (14) if the first selected parameter does not comply with an acceptable risk profile for the well operation or a phase of the well operation.

14. The method (10) according to any preceding claim, wherein the first selected parameter comprises a tripping/pulling speed of a string or tubular in the wellbore, and the method comprises determining a range of tripping speeds that comply with an acceptable risk profile for the well operation or a phase of the well operation.

15. The method (10) according to any preceding claim, comprising outputting risk information to a control system (18) for the well operation, and controlling one or more parameters of the well operation automatically using the control system.

## Patentansprüche

1. Ein Verfahren (10) zum Planen oder Durchführen eines Offshore-Bohrlochvorgangs, der von einer schwimmenden Offshorestruktur (16) aus in einem Unterwasserbohrloch durchgeführt wird, wobei das Verfahren Folgendes umfasst:
Vorhersagen der Auswirkung von Hub auf den Bohrlochvorgang durch:
Bereitstellen von Hubbewegungsdaten (22) für die schwimmende Offshorestruktur an ein Verarbeitungsmodul (12);
Ausführen eines Bohrlochvorgangs-Simulationsmodells (20) auf dem Verarbeitungsmodul;
Berechnen eines Bohrlochdrucks (24) unter Verwendung des Bohrlochvorgangs-Simulationsmodells, wobei die Berechnung des Bohrlochdrucks die Hubbewegungsdaten verwendet, um die Auswirkung der Hubbewegung auf den Bohrlochvorgang zu berechnen;
Vergleichen des berechneten Bohrlochdrucks mit mindestens einer Druckspanne für das Unterwasserbohrloch, um ein Risiko zu bestimmen, das mit einer geplanten Deaktivierung eines Hubkompensationssystems während des Bohrlochvorgangs verbunden ist, und
Ausgeben von Risikoinformationen vom Verarbeitungsmodul.

2. Das Verfahren (10) gemäß einem der vorhergehenden Ansprüche, wobei der Bohrlochvorgang ein Bohrvorgang, ein Vervollständigungsvorgang oder ein Interventionsvorgang ist.

3. Das Verfahren (10) gemäß einem der vorhergehenden Ansprüche, wobei die Daten zur Hubbewegung (22) aus Eingabedaten (30) berechnet werden, die sich auf eine oder mehrere Wetterbedingungen und/oder Seegangsbedingungen beziehen.

4. Das Verfahren (10) gemäß einem der vorhergehenden Ansprüche, wobei die Daten zur Hubbewegung (22) eine stochastische Zeitreihe einer erwarteten Hubbewegung umfassen, die aus Eingabedaten (30) unter Verwendung eines Antwortamplitudenoperators (RAO) der Offshorestruktur berechnet wird.

5. Das Verfahren (10) gemäß einem der vorhergehenden Ansprüche, wobei der Bohrlochvorgang eine Stange oder ein Rohr verwendet, die bzw. das aus Abschnitten gebildet ist, die an Stangen- oder Rohrverbindungen zusammengefügt sind, und wobei der Bohrlochvorgang das Herstellen und/oder Aufbrechen einer Stangen- oder Rohrverbindung umfassen kann, und wobei das Verfahren das Kategorisieren eines geplanten Herstellens oder Aufbrechens einer Stangen- oder Rohrverbindung gemäß einem Risikoniveau umfasst.

6. Das Verfahren (10) gemäß einem der vorhergehenden Ansprüche, das das Bereitstellen eines Empfehlungssignals zur Unterstützung der Entscheidungsfindung bezüglich der geplanten Deaktivierung des Hubkompensationssystems während einer bevorstehenden Phase des Vorgangs umfasst.

7. Das Verfahren (10) gemäß einem der vorhergehenden Ansprüche, das Folgendes umfasst:
Kategorisieren einer geplanten Deaktivierung eines Hubkompensationssystems während einer bevorstehenden Phase des Vorgangs basierend auf prognostizierten Wellendaten und/oder prognostizierten Wetterdaten an einem Vorgangsstandort und Bereitstellen eines Empfehlungssignals zur Unterstützung der Entscheidungsfindung bezüglich der geplanten Deaktivierung des Hubkompensationssystems während der bevorstehenden Phase des Vorgangs.

8. Das Verfahren (10) gemäß einem der vorhergehenden Ansprüche, das das Aktualisieren eines oder mehrerer Parameter des Bohrlochvorgangs-Simulationsmodells (20) und das Ausführen der Bohrlochvorgangssimulation mit den aktualisierten einem oder mehreren Parametern umfasst, um einen Bohrlochdruck (24) unter Verwendung der Hubbewegungsdaten (22) und aktualisierten einem oder mehreren Parametern zu berechnen, um die Auswirkung der Hubbewegung auf den Bohrlochvorgang zu berechnen.

9. Das Verfahren (10) gemäß einem der vorhergehenden Ansprüche, das das Aktualisieren der Hubbewegungsdaten (22) und das Ausführen der Bohrlochvorgangssimulation (20) mit den aktualisierten Hubbewegungsdaten umfasst, um einen Bohrlochdruck (24) zu berechnen.

10. Das Verfahren (10) gemäß Anspruch 9, wobei die Hubbewegungsdaten (22) aktualisiert werden, indem aktualisierte Hubbewegungsdaten aus aktualisierten Eingabedaten (30) berechnet werden, die sich auf eine oder mehrere Wetterbedingungen und/oder Seegangsbedingungen beziehen.

11. Das Verfahren (10) gemäß einem der vorhergehenden Ansprüche, das das regelmäßige, kontinuierliche oder in Echtzeit erfolgende Aktualisieren des Bohrlochvorgangs-Simulationsmodells (20) und/oder der Hubbewegungsdaten (22) entsprechend der Verfügbarkeit neuer oder aktualisierter Bohrlochvorgangsparameter und/oder Hubbewegungsdaten umfasst.

12. Das Verfahren (10) gemäß einem der vorhergehenden Ansprüche, das das Bestimmen eines Wertes oder Wertebereichs für einen ersten ausgewählten Parameter, der einem akzeptablen Risikoprofil für den Bohrlochvorgang oder eine Phase des Bohrlochvorgangs entspricht, und das Ausgeben des Wertes oder Wertebereichs für den ersten ausgewählten Parameter aus dem Verarbeitungsmodul (12) umfasst.

13. Das Verfahren (10) gemäß Anspruch 12, das das Aktivieren eines Alarmsignals an einen Bediener (14) umfasst, wenn der erste ausgewählte Parameter nicht einem akzeptablen Risikoprofil für den Bohrlochvorgang oder eine Phase des Bohrlochvorgangs entspricht.

14. Das Verfahren (10) gemäß einem der vorhergehenden Ansprüche, wobei der erste ausgewählte Parameter eine Auslöse-/Ziehgeschwindigkeit eines Strangs oder Rohrs im Bohrloch umfasst, und das Verfahren das Bestimmen eines Bereichs von Auslösegeschwindigkeiten umfasst, die einem akzeptablen Risikoprofil für den Bohrlochvorgang oder eine Phase des Bohrlochvorgangs entsprechen.

15. Das Verfahren (10) gemäß einem der vorhergehenden Ansprüche, das das Ausgeben von Risikoinformationen an ein Steuersystem (18) für den Bohrlochvorgang und das automatische Steuern eines oder mehrerer Parameter des Bohrlochvorgangs unter Verwendung des Steuersystems umfasst.

## Revendications

1. Procédé (10) de planification ou de réalisation d'une opération de puits offshore réalisée depuis une structure offshore flottante (16) dans un puits sous-marin, le procédé consistant à :
prédire l'effet de la houle sur l'opération du puits en :
fournissant des données de mouvement de houle (22) pour la structure offshore flottante à un module de traitement (12) ;
en exécutant un modèle de simulation d'opération du puits (20) sur le module de traitement ;
en calculant une pression de puits de forage (24) à l'aide du modèle de simulation d'opération du puits, dans lequel le calcul de la pression de puits de forage utilise les données de mouvement de houle pour calculer l'effet de mouvement de houle sur l'opération du puits ;
en comparant la pression de puits de forage calculée avec au moins une marge de pression pour le puits sous-marin afin de déterminer un risque associé à une désactivation programmée d'un système de compensation de houle pendant l'opération du puits ; et
en obtenant des informations de risque de la part du module de traitement.

2. Procédé (10) selon l'une quelconque des revendications précédentes, dans lequel l'opération du puits est une opération de forage, une opération de complétion ou une opération d'intervention.

3. Procédé (10) selon l'une quelconque des revendications précédentes, dans lequel les données de mouvement de houle (22) sont calculées à partir de données entrantes (30) concernant une ou plusieurs conditions météorologiques et/ou conditions d'état de la mer.

4. Procédé (10) selon l'une quelconque des revendications précédentes, dans lequel les données de mouvement de houle (22) comprennent une série temporelle stochastique d'un mouvement de houle inattendu, calculé à partir de données entrantes (30) à l'aide d'une fonction de transfert (RAO) de la structure offshore.

5. Procédé (10) selon l'une quelconque des revendications précédentes, dans lequel l'opération du puits utilise une tige ou un tube formé(e) à partir des sections assemblées au niveau des raccords de tige ou de tube, et l'opération du puits peut inclure de créer et/ou de rompre un raccord de tige ou de tube, et le procédé comprenant la catégorisation d'une création ou d'une rupture programmée d'un raccord de tige ou de tube en fonction d'un niveau de risque.

6. Procédé (10) selon l'une quelconque des revendications précédentes, consistant à envoyer un signal de recommandation pour faciliter la prise de décision concernant la désactivation programmée du système de compensation de houle pendant une phase à venir de l'opération.

7. Procédé (10) selon l'une quelconque des revendications précédentes, consistant à :
catégoriser une désactivation programmée d'un système de compensation de houle pendant une phase à venir de l'opération en fonction des données de prédiction de vagues et/ou des données de prédictions météorologiques au niveau d'un site d'opération ;
et envoyer un signal de recommandation pour faciliter la prise de décision concernant la désactivation programmée du système de compensation de houle pendant la phase à venir de l'opération.

8. Procédé (10) selon l'une quelconque des revendications précédentes, consistant à mettre à jour un ou plusieurs paramètres du modèle de simulation d'opération du puits (20) et à exécuter la simulation d'opération du puits avec le ou les paramètres mis à jour pour calculer une pression de puits de forage (24) à l'aide des données de mouvement de houle (22) et un ou plusieurs paramètres mis à jour pour calculer l'effet du mouvement de houle sur l'opération du puits.

9. Procédé (10) selon l'une quelconque des revendications précédentes, consistant à mettre à jour des données de mouvement de houle (22) et à exécuter la simulation d'opération du puits (20) avec les données de mouvement de houle mises à jour pour calculer une pression de puits de forage (24).

10. Procédé (10) selon la revendication 9, dans lequel les données de mouvement de houle (22) sont mises à jour en calculant des données de mouvement de houle mises à jour à partir de données entrantes mises à jour (30) concernant une ou plusieurs conditions météorologiques et/ou conditions d'état de la mer.

11. Procédé (10) selon l'une quelconque des revendications précédentes, consistant à mettre à jour le modèle de simulation d'opération du puits (20) et/ou les données de mouvement de houle (22), régulièrement, de manière continue ou en temps réel, en fonction de la disponibilité des paramètres d'opération du puits nouveaux ou mis à jour et/ou des données de mouvement de houle nouvelles ou mises à jour.

12. Procédé (10) selon l'une quelconque des revendications précédentes, consistant à déterminer une valeur ou une plage de valeurs pour un premier paramètre sélectionné qui correspond à un profil de risque acceptable pour l'opération du puits ou une phase de l'opération du puits, et à obtenir la valeur ou plage de valeurs pour le premier paramètre sélectionné auprès du module de traitement (12).

13. Procédé (10) selon la revendication 12, consistant à activer un signal d'alarme à l'attention d'un opérateur (14) si le premier paramètre sélectionné ne correspond pas à un profil de risque acceptable pour l'opération du puits ou une phase de l'opération du puits.

14. Procédé (10) selon l'une quelconque des revendications précédentes, dans lequel le premier paramètre sélectionné comprend une vitesse de déclenchement/tirage d'une tige ou d'un tube dans le puits de forage, et le procédé consiste à déterminer une plage de vitesses de déclenchement qui correspond à un profil de risque acceptable pour l'opération du puits ou une phase de l'opération du puits.

15. Procédé (10) selon l'une quelconque des revendications précédentes, comprenant la transmission d'informations de risque vers un système de contrôle (18) pour l'opération du puits, et le contrôle automatique d'un ou plusieurs paramètres de l'opération du puits à l'aide du système de contrôle.
